# EUROPÄISCHE PATENTANMELDUNG

(11) **EP 2 017 895 A2**
(43) Veröffentlichungstag der Anmeldung: **21.01.2009**
(21) Anmeldenummer: 08010248.6
(22) Anmeldetag: 05.06.2008
(51) Int. Cl.: H01L 31/075

(54) **Silizium-Mehrfachsolarzelle und Verfahren zu deren Herstellung**

(30) Priorität: 18.07.2007 DE 102007033444
(71) Anmelder: SCHOTT Solar GmbH, 63755 Alzenau (DE)
(72) Erfinder: Frammelsberger, Walter, 84524 Neuötting (DE); Lechner, Peter, 85591 Vaterstetten (DE)
(74) Vertreter: Haft, von Puttkamer, Berngruber

(57) **Zusammenfassung**

Eine Silizium-Mehrfachsolarzelle weist wenigstens zwei Teilzellen (1, 2) mit jeweils einer p-leitenden Schicht (p1, p2), einer intrinsischen Schicht (il, i2) und einer mit Phosphor dotierten n-leitenden Schicht (n1, n2) auf. Die p-leitende Schicht (p2), die mit der n-leitenden Schicht (n1) der davor angeordneten Teilzelle (1) in Kontakt steht, ist zumindest teilweise nano- oder mikrokristallin ausgebildet.

## Beschreibung

Die Erfindung bezieht sich auf eine Silizium-Mehrfachsolarzelle nach dem Oberbegriff des Anspruchs 1 und ein Verfahren zu deren Herstellung.

Silizium-Solarzellen weisen im Allgemeinen die Schichtfolge p-i-n, d.h. eine p-leitende oder p-Schicht, eine intrinsische oder i-Schicht und eine n-leitende oder n-Schicht auf, wobei über die gesamte i-Schicht ein elektrisches Feld erzeugt wird. Durch Mehrfachzellen, die aus Teilzellen bestehen, die jeweils eine p-i-n-Schichtfolge aufweisen, kann das elektrische Feld wesentlich vergrößert werden.

Zur Herstellung der Mehrfachzellen wird häufig die chemische Dampfabscheidung ("Chemcial Vapor Deposition" oder CVD) verwendet, insbesondere das Plasma unterstützte PE ("Plasma Enhanced") CVD-Verfahren.

Die Schichten der einzelnen Teilzellen werden durch das Zerlegen von Silizium enthaltenden Gasen in dem Plasma hergestellt. Als Depositionsgas dient hierbei meist Silan (SiH₄) oder Disilan (Si₂H₆). Neben dem (undotierten) i-Schichten werden die dotierten p- und n-Schichten abgeschieden, und zwar die p-Schichten, durch die das Licht in die i-Schichten fällt, üblicherweise durch Zugabe von Bor, insbesondere durch Beimengung von Diboran (B₂H₆) oder Trimethylbor (B(CH₃)₃) zum Depositionsgas und die n-Schicht durch Zugabe von Phosphor, beispielsweise durch Beimengung von Phosphin zum Depositionsgas.

Für eine kostengünstige Herstellung der Silizium-Mehrfachsolarzellen hat sich insbesondere der Einkammerprozess als besonders geeignet erwiesen, wonach die Abscheidung sämtlicher Schichten der Mehrfachsolarzelle in der Schichtfolge p-i-n-p-i-n- nacheinander in ein und demselben Reaktor erfolgt, also ohne dass der Reaktor zwischen der Abscheidung der dotierten und intrinsischen Schichten gereinigt wird. Damit kann beim PECVD-Verfahren die Abscheidung der einzelnen Schichten ohne Unterbrechung des Plasmas durchgeführt werden.

Aufgrund der schnellen Abscheidungsgeschwindigkeit werden bevorzugt p-, i- und n-Schichten aus amorphem Silizium abgeschieden.

Die Qualität einer Silizium-Mehrfachsolarzelle von p-i-n-Typ wird wesentlich von der Qualität der intrinsischen Schichten bestimmt. Es ist daher notwendig, die Defektdichte der intrinsischen Schichten einer Silizium-Mehrfachsolarzelle so gering wie möglich zu halten.

Aufgabe der Erfindung ist es daher, die Defektdichte der intrinsischen Schichten einer Silizium-Mehrfachsolarzelle wesentlich herabzusetzen.

Dies wird erfindungsgemäß mit der im Anspruch 1 gekennzeichneten Silizium-Mehrfachsolarzelle erreicht. In den Ansprüchen 2 bis 6 sind vorteilhafte Ausgestaltungen der Erfindung wiedergegeben.

Die erfindungsgemäße Silizium-Mehrfachsolarzelle besteht aus wenigstens zwei Teilzellen, die jeweils aus einer p-Schicht, einer darauf abgeschiedenen i-Schicht und einer auf der i-Schicht abgeschiedenen mit Phosphor dotierten n-Schicht bestehen.

Dabei liegt der Erfindung die Feststellung zugrunde, dass neben den Defekten, die durch ungesättigte Bindungselektronen verursacht werden, insbesondere eine unbeabsichtigte Dotierung zu Defekten der intrinsischen Schichten führen. Diese Gefahr besteht insbesondere im Einkammerprozess, da hierbei Dotierelemente aus den zuvor abgeschiedenen dotierten Schichten in die intrinsischen Schichten verschleppt werden können. Als mögliche Quellen kommen z.B. ungenügend gebundene Dotierelemente in Frage, die an den Reaktorwänden und bei dem PECVD-Verfahren auch an der Elektrode des PECVD-Reaktors beim Einkammerprozess in der gleichen Weise abgeschieden werden wie die Mehrfachzelle auf dem Substrat.

Dabei spielt insbesondere die Verschleppung des zur Dotierung der n-Schichten erforderlichen Phosphors eine wesentliche Rolle.

Erfindungsgemäß konnte nun festgestellt werden, dass sich die Verschleppung des Phosphors in die intrinsischen Schichten weitgehend ausschließen lässt, wenn die p-Schicht der zweiten bzw. jeder weiteren nachfolgenden Teilzelle, die auf der mit Phosphor dotierten n-Schicht der ersten bzw. vorhergehenden Teilzelle abgeschieden wird, zumindest teilweise nano- oder mikrokristallin ausgebildet ist. Unter nano- oder mikrokristallinem Silizium ist dabei ein Silizium aus Kristallen mit einer Größe von 1 nm bis 1 µm, insbesondere 10 bis 100 nm zu verstehen.

Die erfindungsgemäße Solarzelle kann z.B. eine Tandemzelle mit zwei Teilzellen oder eine Tripelzelle mit drei Teilzellen, jeweils mit einer p-i-n-Schichtfolge sein, wobei das Licht durch das p-Schicht in die intrinsische Schicht der jeweiligen Teilzelle fällt.

Die Herstellung der erfindungsgemäßen Silizium-Mehrfachsolarzelle erfolgt vorzugsweise durch CVD im Einkammerprozess, d.h. die Abscheidung in der Schichtfolge p-i-n der ersten Teilzelle und jeder weiteren Teilzelle folgt durch CVD in ein und demselben Reaktor. Dabei wird vorzugsweise das PECVD-Verfahren durchgeführt.

Als Depositionsgas wird vorzugsweise Silan, Disilan oder ein anderes Silanwasserstoffgas verwendet, wobei dem Depositionsgas Wasserstoff (H₂) oder Edelgase beigemischt werden können. Das Plasma zur Zerlegung der Gase beim PECVD-Verfahren kann durch Anliegen einer Gleichspannung oder Wechselspannung erzeugt werden. Die Frequenzbereiche für das elektrische Wechselfeld erstrecken sich vom niederfrequenten Kiloherzbereich über Radiofrequenzen im MHz-Bereich bis hin zu Mikrowellen im GHz-Bereich. Vorzugsweise wird ein elektrisches Wechselfeld mit einer Frequenz im Bereich von 1 bis 100 MHz verwendet.

Um die p-Schicht, die mit der n-Schicht der zuvor abgeschiedenen Teilzelle in Kontakt steht, zumindest teilweise nano- oder mikrokristallin auszubilden, wird ein Depositionsgas mit einem hohen Anteil an Wasserstoff (H₂) verwendet, um im Depositionsgas reaktive Wasserstoffatome zu bilden, auch wird üblicherweise der Gasdruck erhöht, und bei einem PECVD-Prozess mit elektrischem Wechselfeld die Frequenz zur Aktivierung des Wasserstoffs im Depositionsgas.

Die zumindest teilweise nano- oder mikrokristalline p-Schicht, die erfindungsgemäß mit der zuvor abgeschiedenen n-Schicht der in Lichteinfallsrichtung davor angeordneten Teilzelle in Kontakt steht, bildet eine Barriereschicht, der eine Verschleppung des Phosphors aus der zuvor abgeschiedenen n-Schicht verhindert.

Die intrinsischen Schichten der erfindungsgemäßen Mehrfachsolarzelle bestehen vorzugsweise aus amorphen Silizium, das wesentlich schneller als nano- oder mikrokristallines Silizium abgeschieden wird.

Die n-Schicht, die mit der p-Schicht der nachfolgenden Teilzelle in Kontakt steht, kann aus amorphen Silizium bestehen, vorzugsweise weist die n-Schicht an der Grenzfläche zur p-Schicht jedoch eine Teilschicht aus nano-oder mikrokristallinem Silizium auf, während der restliche Teil der n-Schicht amorph ist. Dadurch wird ein geringer Serienwiderstand und damit ein hoher Füllfaktor an dem n/p-Kontakt gebildet.

Die p-Schicht, die mit der n-Schicht der davor angeordneten Teilzelle in Kontakt steht, kann vollständig aus nano- oder mikrokristallinem Silizium bestehen. Vorzugsweise ist jedoch nur eine Teilschicht der p-Schicht nano- oder mikrokristallin, während der restliche Teil amorph ist, um die p-Schicht schneller abzuscheiden.

Vorzugsweise ist dabei die Teilschicht der p-Schicht an der Grenzfläche zur n-Schicht nano- oder mikrokristallin, während der restliche Teil der p-Schicht amorph ist. Durch die nano- oder mikrokristalline Teilschicht der p-Schicht an der Grenzfläche zur n-Schicht wird der Serienwiderstand an dem n/p-Kontakt herabgesetzt und damit der Füllfaktor erhöht.

D.h. eine erfindungsgemäße Mehrfachzelle besteht vorzugsweise z.B. aus folgender Schichtfolge: amorphe p-Schicht, amorphe i-Schicht, amorphe n-Schicht oder amorphe n-Teilschicht, nano- oder mikrokristalline n-Teilschicht als 1. Teilzelle und nano- oder mikrokristalline p-Teilschicht, amorphe p-Teilschicht, amorphe i-Schicht, amorphe n-Schicht als letzte Teilzelle, wobei weitere Teilzellen zwischen der ersten und der letzten Teilzelle vorzugsweise jeweils aus folgender Schichtfolge bestehen: einer nano- oder mikrokristallinen p-Teilschicht, einer amorphen p-Teilschicht, einer amorphen i-Schicht und einer amorphen n-Schicht oder einer amorphen n-Teilschicht und einer nano- oder mikrokristallinen n-Teilschicht.

Die Schichtdicke der p-Schicht, die im Kontakt mit der n-Schicht der davor angeordneten Teilzelle steht, beträgt insgesamt vorzugsweise 5 bis 30 nm, insbesondere 8 bis 10 nm. Die nano- oder mikrokristalline Teilschicht der p-Schicht weist dabei vorzugsweise eine Schichtdicke von mindestens 2 nm, insbesondere 3 bis 5 nm auf.

Die Schichtdicke der n-Schicht, die mit der p-Schicht der nachfolgenden Teilzelle in Kontakt steht, beträgt vorzugsweise 5 bis 30 nm, insbesondere 8 bis 15 nm.

Die p-leitende Schicht, die mit der n-leitenden Schicht der zuvor angeordneten Teilzelle in Kontakt steht, ist vorzugsweise mit Kohlenstoff, Sauerstoff oder Stickstoff ggf. auch einem Gemisch dieser Elemente legiert, um die Bandlücke zu vergrößern.

Dazu kann bei der Herstellung der p-Schicht dem Depositionsgas ein Gas beigemengt werden, das diese Elemente enthält. Dies verringert die Lichtabsorbanz der p-Schicht, durch die das Licht in die intrinsische Schicht fällt.

Während die Dotierung der n-Schichten mit einem phosphorhaltigen Gas, insbesondere Phosphin, durchgeführt wird, das dem Depositionsgas beigemischt wird, werden die p-Schichten üblicherweise durch Beimengung von Diboran oder Trimethylbor zum Depositionsgas hergestellt.

Ansonsten entspricht die erfindungsgemäße Silizium-Mehrfachsolarzelle dem Stand der Technik, d.h. sie weist, wie üblich, eine transparente Elektrodenschicht auf der vorderen p-Schicht der ersten Teilzelle an der Lichteinfallsseite und eine Elektrodenschicht an der rückwärtigen n-Schicht auf, ferner beispielsweise eine transparente Trägerplatte an der Lichteinfallsseite, die im Allgemeinen zugleich das Substrat zur Abscheidung der Mehrfachsolarzelle bildet

In der beigefügten Zeichnung zeigen:
- Figur 1: schematisch den Aufbau einer üblichen Silizium-Tandemzelle;
- Figur 2: ein Diagramm mit der Kennlinie einer üblichen Tandemzelle nach dem nachstehenden Beispiel 1;
- Figur 3: schematisch und beispielhaft den Aufbau einer erfindungsgemäßen Silizium- Tandemzelle; und
- Figur 4: ein Diagramm mit der Kennlinie der erfindungsgemäßen Tandemzelle nach dem Beispiel 2.

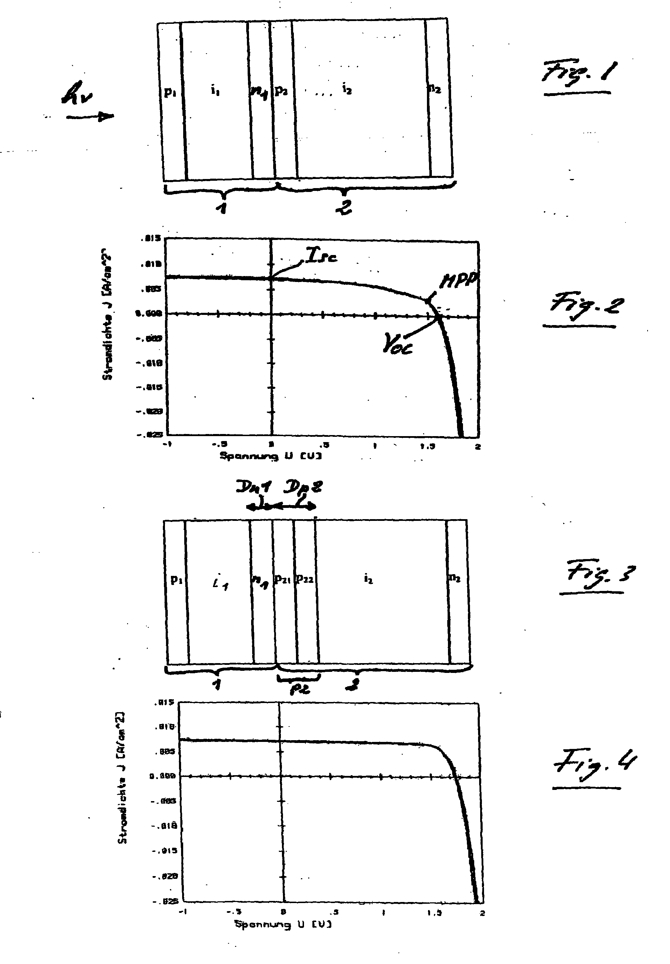

Gemäß Figur 1 weist die herkömmliche Silizium-Tandemzelle eine erste Teilzelle 1 auf, auf die das Licht fällt, und eine zweite Teilzelle 2. Die erste und die zweite Teilzelle 1, 2 sind jeweils als p-i-n-Zelle ausgebildet, d.h. sie weisen an ihrer vorderen, also Lichteinfallsseite jeweils eine p-Schicht, p1, p2 und an ihrer rückwärtigen Seite jeweils eine n-Schicht n1, n2 auf, wobei die n-Schicht n1 der ersten Teilzelle 1 und die p-Schicht p2 der zweiten Teilzelle 2 miteinander in Kontakt stehen. Zwischen den p-Schichten p1, p2 und den n-Schichten n1, n2 jeder Teilzelle 1, 2 ist jeweils eine intrinsische oder i-Schicht i1, i2 vorgesehen. Die p-Schichten p1, p2 und die intrinsischen Schichten i1, i2 bestehen jeweils aus amorphen Silizium, ebenso die n-Schichten n1, n2.

Die erfindungsgemäße Tandemzelle nach Figur 3 unterscheidet sich von derjenigen in Figur 1 im Wesentlichen dadurch, dass die p-Schicht p2 der zweiten Teilzelle 2, die mit der n-Schicht n1 der ersten Teilzelle 1 in Kontakt steht, aus einer ersten Teilschicht p21 aus nano- oder mikrokristallinem Silizium besteht, die in Kontakt mit der n-Schicht n1 der ersten Teilzelle 1 steht, sowie einer zweiten Teilschicht p22 aus amorphen Silizium, die in Kontakt mit der intrinsischen Schicht i2 der zweiten Teilzelle 2 steht. Ferner weist die p-Schicht p2 der zweiten Teilzelle 2, die in Kontakt mit der n-Schicht n1 der ersten Teilzelle 1 steht, eine größere Schichtdicke Dp2 gegenüber der Schichtdicke Dn1 der n-Schicht n1 auf.

### Beispiel 1 (Vergleich):

Es wurde eine übliche Silizium-Tandemsolarzelle gemäß Figur 1 im Einkammerprozess durch PECVD in einem elektrischen Wechselfeld (Frequenz 13,56 MHz) hergestellt. Die Schichtdicke der mit Kohlenstoff legierten, mit Bor dotierten amorphen p-Schichten p1 und p2 beträgt jeweils 8 nm, der mit Phosphor dotierten, amorphen n-Schichten n1 und n2 jeweils 10 nm und der amorphen intrinsischen Schichten i1 und i2 jeweils 300 nm.

In Figur 2 ist die Kennlinie der Tandemsolarzelle dargestellt. Dabei stellt MPP den Maximum Power Point, I_{sc} den Kurzschlussstrom und V_{oc} die Leerlaufspannung dar.

Der Füllfaktor beträgt 53 %. Durch Sekundärionenmassenspektrometrie (SIMS) wurde am Beginn der intrinsischen Schicht i2 der zweiten Teilzelle 2 eine Phosphorkonzentration von mehr als 1 x 10⁸ cm⁻³ nachgewiesen.

### Beispiel 2:

Das Beispiel 1 wurde wiederholt, außer dass eine Tandemsolarzelle hergestellt wurde, deren n-Schicht n1 der ersten Teilzelle 1 eine Schichtdicke von 5 nm aufwies, wobei die vordere p-Schicht p2 der zweiten Teilzelle 2 an der Grenzfläche zur n-Schicht n1 der ersten Teilzelle 1 aus einer ersten Teilschicht p21 aus nano- oder mikrokristallinem Silizium mit einer Schichtdicke von 5 nm bestand, sowie aus einer daran anschließenden zweiten Teilschicht p22 aus amorphen Silizium mit einer Schichtdicke von 8 nm.

In Figur 4 ist die Kennlinie der Tandemsolarzelle dargestellt. Sie weist einen Füllfaktor von 76 % auf.

## Patentansprüche

1. Silizium-Mehrfachsolarzelle aus wenigstens zwei Teilzellen (1, 2), die jeweils eine p-leitende Schicht (p1, p2), eine intrinsische Schicht (i1, i2) und eine mit Phosphor dotierte n-leitende Schicht (n1, n2) aufweisen, wobei das Licht durch die p-leitende Schicht (p1, p2) in die intrinsische Schicht (i1, i2) der jeweiligen Teilzelle (1, 2) fällt, und die p-leitende Schicht (p2) eine erste Teilschicht (p21) an der Grenzfläche zu der n-leitenden Schicht (n1) der davor angeordneten Teilzelle (1) und eine zweite, amorphe Teilschicht (p22) aufweist, **dadurch gekennzeichnet, dass** die erste Teilschicht (p21) der p-leitenden Schicht (p2) aus nanokristallinem Silizium aus Kristallen mit einer Größe von 1 bis 100 nm besteht und eine Schichtdicke von mindestens 2 nm aufweist und die n-leitende Schicht (n1) eine geringere Schichtdicke (Dn2) aufweist als die Schichtdicke (Dp2) der damit in Kontakt stehenden p-leitenden Schicht (p2) der nachfolgenden Teilzelle (2).

2. Silizium-Mehrfachsolarzelle nach Anspruch 1, **dadurch gekennzeichnet, dass** die intrinsischen Schichten (i1, i2) aus amorphem Silizium bestehen.

3. Silizium-Mehrfachsolarzelle nach einem der vorstehenden Ansprüche, **dadurch gekennzeichnet, dass** die n-leitenden Schicht (n1), die in Kontakt mit der p-leitenden Schicht (p2) der nachfolgenden Teilzelle (2) steht, zumindest teilweise amorph ausgebildet ist.

4. Silizium-Mehrfachsolarzelle nach Anspruch 3, **dadurch gekennzeichnet, dass** die n-leitenden Schicht (n1) eine amorphe Teilschicht und an der Grenzfläche zu der p-leitenden Schicht (p2) der nachfolgenden Teilzelle (2) eine nano- oder mikrokristalline Teilschicht aufweist.

5. Silizium-Mehrfachsolarzelle nach einem der vorstehenden Ansprüche, **dadurch gekennzeichnet, dass** die n-leitende Schicht (n1), die in Kontakt mit der p-leitenden Schicht (p2) der nachfolgenden Teilzelle (2) steht, eine Schichtdicke von 20 nm oder weniger aufweist.

6. Silizium-Mehfachsolarzelle nach Anspruch 1, **dadurch gekennzeichnet, dass** die p-leitende Schicht (p2) die mit der n-leitenden Schicht (n1) der davor angeordneten Teilzelle (1) in Kontakt steht, durch Legierung mit Kohlenstoff, Sauerstoff oder Stickstoff eine vergrößerte Bandlücke aufweist.
